# EUROPÄISCHE PATENTSCHRIFT

(11) **EP 0 279 030 B1**
(45) Veröffentlichungstag und Bekanntmachung des Hinweises auf die Patenterteilung: **07.04.1993**
(21) Anmeldenummer: 87116198.0
(22) Anmeldetag: 04.11.1987
(51) Int. Cl.: H05K 3/34, B23K 35/30, B23K 35/00

(54) **Lötfähiges Schichtsystem**
Solderable layer system
Ensemble de couches soudable

(30) Priorität: 19.02.1987 DE 3705258
(43) Veröffentlichungstag der Anmeldung: 24.08.1988
(73) Patentinhaber: VDO Adolf Schindling AG, D-60487 Frankfurt (DE)
(72) Erfinder: Schurig, Dieter, D-6274 Wallrabenstein (DE)
(74) Vertreter: Klein, Thomas, Dipl.-Ing. (FH)

(56) Entgegenhaltungen:
- EP-A- 0 060 968
- EP-A- 0 170 444
- DE-B- 2 948 253
- US-A- 4 424 408
- US-A- 4 441 118
- WELDING JOURNAL, Band 34, Nr. 7, Juli 1955, Seiten 321-s - 337-s; I.T. HOOK: "The welding of copper and its alloys"

## Beschreibung

Die Erfindung betrifft ein lötfähiges Schichtsystem, bei welchem auf einem Träger eine Leiterschicht aufgebracht ist, die teilweise mit einer Lötschicht bedeckt ist.

Bei elektrischen Schaltungen und Bauelementen werden für Leiterbahnen häufig Werkstoffe verwendet, die als olche nicht lötfähig sind. Um diese Leiterbahnen jedoch mit Lötstellen zu versehen, ist es bekannt, eine Lötschicht auf derartige Leiterschichten aufzubringen. Häufig wird zur Verbesserung der Haftung der Lötschicht auf der Leiterschicht noch eine Zwischenschicht als Haftvermittler aufgebracht. Schließlich wird bei bekannten Schichtsystemen noch eine Korrosionsschicht auf die Lötschicht aufgebracht - unter anderem um eine vorübergehende Lagerung der mit der Lötschicht versehenen Teile bis zum Lötvorgang zu ermöglichen.

Derartige Schichtsysteme erfordern einen erheblichen Herstellungsaufwand. Außerdem läßt häufig bei den bekannten Schichtsystemen die Wirkung des Haftvermittlers durch Alterungsvorgänge nach.

Aus der DE-B-29 48 253 ist eine elektronische Dünnschichtschaltung bekannt, die einen aus Isoliermaterial bestehenden Träger aufweist, der teilweise von einer elektrisch leitenden Metalloxidschicht (SnO₂-Schicht) bedeckt ist. Um eine verbesserte Haftung einer auf die Metalloxidschicht aufzubringenden Lötschicht aus Gold zu erreichen, wird die Metallschicht vor Aufbringen der Lötschicht teilweise reduziert.

Aufgabe der vorliegenden Erfindung ist es ein lötfähiges Schichtsystem der eingangs genannten Art zu schaffen, das möglichst einfach und beständig ist.

Das erfindungsgemäße Schichtsystem ist dadurch gekennzeichnet, daß die Leiterschicht Zinn-Oxid enthält und die Lötschicht aus einer Legierung besteht, in welcher als Reduktionsmittel Zink enthalten ist, welches durch thermische Belastung mindestens teilweise in die Grenzflächen der Lötschicht diffundiert ist.

Das erfindungsgemäße Schichtsystem ist mit einfachen Verfahren preiswert herzustellen und außerdem alterungsbeständig.

Eine Weiterbildung der Erfindung besteht darin, daß die Legierung Messing ist.

Eine Diffusion des Reduktionsmittels in die äußeren Beriche der Lötschicht erfolgt auch bei späteren Temperaturerhöhungen, beispielsweise bei dem Lötvorgang, so daß dann eine Fortsetzung des mit der Erfindung genutzten Diffusionsvorganges stattfindet. Die im einzelnen an Hand des Ausführungsbeispiels erläuterte Haftung zwischen der Leiterschicht und der Lötschicht wird daher durch spätere thermische Bela.... stungen nicht herabgesetzt, sondern allenfalls erhöht.

Die Erfindung läßt zahlreiche Ausführungsformen zu. Eine davon ist schematisch in der Zeichnung an Hand mehrerer Figuren dargestellt und nachfolgend beschrieben. Es zeigt:
- Fig. 1: ein bekanntes Schichtsystem und
- Fig. 2: ein erfindungsgemäßes Schichtsystem.

Gleiche Teile sind in den Figuren mit gleichen Bezugszeichen versehen. In den Figuren sind die Schichtsysteme jeweils als Schnittzeichnung vergrößert dargestellt, wobei die Schichtdicken stark überhöht sind.

Bei dem bekannten Schichtsystem ist auf dem Träger 1 eine Leiterschicht 2 aufgebracht, die beispielsweise aus Indium-Zinn-Oxid (ITO) besteht und Teil einer Flüssigkristallzelle ist. Um eine Lötverbindung mit elektronischen Bauelementen, beispielsweise mit sogenannten Chip-Bausteinen zu ermöglichen, ist die Leiterschicht 2 an einer entsprechenden Stelle mit einer Lötschicht 3 versehen. Dafür eignen sich Metalle wie Kupfer oder Eisen. Die Lötschicht 3 ist mit einer Korrosionsschicht 4 abgedeckt, die beispielsweise aus Gold, Silizium, Zinn oder Indium besteht. Zur Verbesserung der Haftung zwischen der Lötschicht 3 und der Leiterschicht 2 ist eine Haftvermittlerschicht 5 vorgesehen. Hierzu eignen sich unter anderem Chrom, Titan oder Aluminium.

Wie ohne weiteres aus dem Schichtaufbau zu erkennen ist, sind zur Herstellung dieses Schichtsystems mehrere Prozeßschritte erforderlich. Dieses führt zu einer Verteuerung der mit dem Schichtsystem versehenen Bauteile.

Außerdem diffundiert das Lot in die Lötschicht. Erreicht das Lot den Grenzbereich zwischen Lötschicht, Haftvermittlerschicht und Leiterschicht, so nimmt die Haftung zwischen der Lötschicht und der Leiterschicht stark ab. Um eine dauerhafte Verbindung zu gewährleisten, sind daher bei den bekannten Schichtsystemen relativ dicke Lötschichten erforderlich.

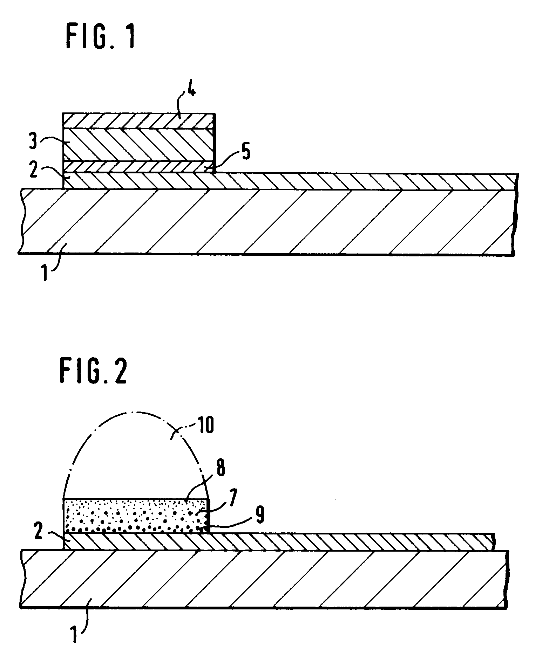

Bei dem in Fig. 2 dargestellten erfindungsgemäßen Schichtsystem ist auf die Leiterschicht 2 eine Lötschicht 7 aus Messing aufgetragen. Bei erhöhter Temperatur diffundiert das im Messing enthaltene Zink an die Grenzflächen der Lötschicht 7. An der Oberfläche 8 der Lötschicht 7 oxidiert das Zink und bildet somit eine Korrosionsschicht. Der an die Grenzfläche 9 zur Leiterschicht diffundierte Anteil des Zinks reagiert mit dem Zinnanteil der Leiterschicht 2, welche beispielsweise aus Indium-Zinn-Oxid besteht. Damit werden die grenznahen Atomlagen des Zinn-Oxid zu metallischem Zinn reduziert, was dann als Haftvermittler zwischen der Leiterschicht 2 und der Lötschicht 7 dient. Das später aufgebrachte Lot 10 ist in Fig. 2 gestrichelt dargestellt.

Im Gegensatz zu dem in Fig. 1 dargestellten bekannten Schichtsystem wirkt sich Lot, welches durch die Lötschicht 7 hindurchdiffundiert, nicht neagtiv auf die Haftung aus. Im Gegenteil: die Haftung kann sogar noch verstärkt werden, da das Lot auf eine metallische Zwischenschicht trifft. Die Lötschicht 7 kann deshalb wesentlich dünner ausgebildet sein, als die bekannte Lötschicht 2 (Fig. 1). Es ist lediglich eine einwandfreie Verzinnung zu gewährleisten.

Auch im Hinblick auf den Lötvorgang weist das erfindungsgemäße Schichtsystem Vorteile auf. Da die Korrosionsschutzschicht, welche durch die Diffusion der Zinkatome an die Oberfläche der Lötschicht 7 entstanden ist, eine äußerst geringe Dicke aufweist, erfolgt auch nur ein geringer Materialverlust beim Entfernen der Korrosionsschutzschicht vor dem Lötvorgang.

## Patentansprüche

1. Lötfähiges Schichtsystem, bei welchem auf einem Träger eine Leiterschicht aufgebracht ist, die teilweise mit einer Lötschicht bedeckt ist, dadurch gekennzeichnet, daß die Leiterschicht (2) Zinn-Oxid enthält und die Lötschicht (7) aus einer Legierung besteht, in welcher als Reduktionsmittel Zink enthalten ist, welches durch thermische Belastung mindestens teilweise in die Grenzflächen (8, 9) der Lötschicht (7) diffundiert ist.

2. Schichtsystem nach Anspruch 2, dadurch gekennzeichnet, daß die Legierung Messing ist.

## Claims

1. Solderable layer system, wherein a conductor layer which is partly covered with a soldering layer is applied to a support, characterised in that the conductor layer (2) contains tin oxide, and the soldering layer (7) consists of an alloy in which there is contained as a reducing agent zinc which is diffused by thermal loading at least partially into the boundary areas (8, 9) of the soldering layer (7).

2. Layer system according to claim 2, characterised in that the alloy is brass.

## Revendications

1. Ensemble de couches permettant une brasure, dans lequel une couche conductrice est déposée sur un support et est partiellement recouverte d'une couche pour brasure, ensemble caractérise en ce que la couche conductrice (2) contient de l'oxyde d'étain et la couche (7) pour brasure consiste en un alliage contenant du zinc comme réducteur, lequel diffuse au moins partiellement, sous l'effet de la contrainte thermique, dans les couches limites (8, 9) de la couche (7) pour brasure.

2. Ensemble de couches selon la revendication 1, caractérisé en ce que l'alliage est du laiton.
